# EUROPEAN PATENT SPECIFICATION

(11) **EP 4 459 271 B1**
(45) Date of publication and mention of the grant of the patent: **06.05.2026**
(21) Application number: 23816256.4
(22) Date of filing: 15.05.2023
(51) Int. Cl.: G01R 31/392, G01R 31/36, G01R 31/52, H01M 10/0525, H01M 10/42, H01M 10/48, H01M 50/569, G01N 23/20

(54) **APPARATUS AND METHOD FOR DIAGNOSING A BATTERY**
VORRICHTUNG UND VERFAHREN ZUR AKKUDIAGNOSE
APPAREIL ET PROCÉDÉ DE DIAGNOSTIC D'UNE BATTERIE RECHARGEABLE

(30) Priority: 31.05.2022 KR 20220066560
(43) Date of publication of application: 06.11.2024
(73) Proprietor: LG Energy Solution, Ltd., Seoul 07335 (KR)
(72) Inventor: KIM, Dae-Soo, Daejeon 34122 (KR); KIM, Young-Deok, Daejeon 34122 (KR)
(74) Representative: Goddar, Heinz J.
(86) International application number: PCT/KR2023/006561
(87) International publication number: WO 2023/234593

(56) References cited:
- JP-A- 2017 072 530
- JP-A- 2017 147 161
- KR-A- 20210 053 748
- KR-A- 20210 146 521
- KR-A- 20220 036 067
- KR-B1- 102 032 507
- HU CHIH-WEI ET AL: "Cyclability evaluation on Si based Negative Electrode in Lithium ion Battery by Graphite Phase Evolution: an operando X-ray diffraction study", SCIENTIFIC REPORTS, vol. 9, no. 1, 4 February 2019 (2019-02-04), XP055966371, DOI: 10.1038/s41598-018-38112-2

## Description

### TECHNICAL FIELD

The present application claims priority to Korean Patent Application No. 10-2022-0066560 filed on May 31, 2022 in the Republic of Korea.

The present disclosure relates to an apparatus and method for diagnosing a battery, and more particularly, to an apparatus and method for diagnosing a battery, which is capable of diagnosing whether an internal tab is disconnected.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

In general, a battery has a structure in which a positive electrode material, a separator, and a negative electrode material are stacked in parallel. Here, a positive electrode tab is connected to each of the plurality of positive electrode materials, and the plurality of positive electrode tabs may be electrically connected to each other through a positive electrode lead. Similarly, a negative electrode tab is connected to each of the plurality of negative electrode materials, and the plurality of negative electrode tabs may be electrically connected to each other through a negative electrode lead.

For example, there is a high possibility that disconnection occurs in the electrode tabs (positive electrode tab and negative electrode tab) of the battery. Since the positive electrode tab and the negative electrode tab are made of a very thin metal film like a positive electrode plate and a negative electrode plate, there is a high probability of being disconnected before other components when an impact is applied to the secondary battery.

If at least one positive electrode tab or at least one negative electrode tab is damaged and disconnected, battery performance may deteriorate and an accident such as fire or explosion may occur. Therefore, it is necessary to develop a technology capable of accurately diagnosing whether the internal tab of the battery is disconnected.

KR 20210053748 A discloses: Provided is a method of predicting a lifespan characteristic of a secondary battery including a carbon-based hybrid negative electrode. The method includes: measuring a lattice spacing (d-spacing) of a carbon-based negative electrode active material of a target carbon-based hybrid negative electrode by using an X-ray diffractometer to plot a variation of a lattice spacing value according to a charging/discharging capacity (X-axis) as a graph during charging and discharging of a target secondary battery including the target carbon-based hybrid negative electrode including the carbon-based negative electrode active material and a non-carbon-based negative electrode active material; calculating a target gradient difference that is a difference between gradient values changed with respect to an inflection point of the graph during the discharging in the plotted graph; comparing the target gradient difference with a reference gradient difference that is a difference between gradient values with respect to an inflection point in a graph showing a variation of a lattice spacing value according to a charging/discharging capacity (X-axis) of a reference secondary battery; and predicting whether a lifespan characteristic of the target secondary battery is improved as compared with the reference secondary battery from a comparison result. Accordingly, the life characteristic is improved.

### DISCLOSURE

### Technical Problem

The present disclosure is designed to solve the problems of the related art, and therefore the present disclosure is directed to providing an apparatus and method for diagnosing a battery, which is capable of accurately diagnosing whether an internal tab of the battery is disconnected.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

The invention is set out in the appended claims. An apparatus for diagnosing a battery according to one aspect of the present disclosure comprises: a discharging unit electrically connected to a battery and configured to discharge the battery; an X-ray diffraction analyzing unit configured to output, while the battery is discharing, an X-ray toward a plurality of negative electrode tabs included in the battery and generate a graphite profile for each of the plurality of negative electrode tabs based on the output X-ray; and a control unit configured to determine a charge and discharge behavior of each of the plurality of negative electrode tabs based on the generated plurality of graphite profiles, and diagnose the state of the battery based on the determined plurality of charge and discharge behaviors.

The control unit may be configured to determine the charge and discharge behavior of each of the plurality of negative electrode tabs as a charge behavior or a discharge behavior by checking an integrated intensity of graphite in each of the plurality of negative electrode tabs based on the plurality of graphite profiles.

The control unit may be configured to determine the charge and discharge behavior of the negative electrode tab in which the integrated intensity decreases as the discharge behavior, and to determine the charge and discharge behavior of the negative electrode tab in which the integrated intensity increases as the charge behavior.

When the discharge behavior is confirmed in the plurality of negative electrode tabs, the control unit may be configured to diagnose the state of the battery as a normal state.

When the charge behavior is confirmed in at least one of the plurality of negative electrode tabs, the control unit may be configured to diagnose the state of the battery as an abnormal state.

The control unit may be configured to diagnose the state of the negative electrode tab in which the charge behavior is confirmed as a disconnected state.

The X-ray diffraction analyzing unit may be configured to output the X-ray in a direction through which the plurality of negative electrode tabs pass.

The X-ray diffraction analyzing unit may be configured to output the X-ray in a stacking direction of the plurality of negative electrode tabs.

The X-ray diffraction analyzing unit may be configured to determine an integrated intensity of graphite for each of the plurality of negative electrode tabs based on diffraction information of the X-ray whenever the X-ray is output, and to generate the graphite profile representing the correspondence between time and the integrated intensity for each the plurality of negative electrode tabs.

A battery test device according to another aspect of the present disclosure may comprise the apparatus for diagnosing a battery according to one aspect of the present disclosure.

A method for diagnosing a battery according to still another aspect of the present disclosure comprises:
a discharging step of discharging a battery; an X-ray outputting step of outputting, while the battery is discharging, an X-ray toward a plurality of negative electrode tabs included in the battery; a graphite profile generating step of generating a graphite profile for each of the plurality of negative electrode tabs based on the output X-ray; a charge and discharge behavior determining step of determining a charge and discharge behavior of each of the plurality of negative electrode tabs based on the plurality of graphite profiles generated in the graphite profile generating step; and a battery state diagnosing step of diagnosing the state of the battery based on the determined plurality of charge and discharge behaviors.

### Advantageous Effects

According to one aspect of the present disclosure, based on a graphite profile generated through an X-ray diffraction analysis method, the state of the battery can be nondestructively diagnosed.

In addition, according to one aspect of the present disclosure, whether or not the negative electrode tab of the battery is disconnected can be specifically diagnosed.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically illustrating an apparatus for diagnosing a battery according to an embodiment of the present disclosure.
FIG. 2 is a diagram schematically illustrating a battery according to an embodiment of the present disclosure.
FIGS. 3 and 4 are diagrams schematically illustrating an internal structure of a battery according to an embodiment of the present disclosure.
FIG. 5 and 6 are diagrams schematically illustrating examples in which X-rays are irradiated to a battery according to an embodiment of the present disclosure.
FIG. 7 is a diagram schematically illustrating a first graphite profile according to an embodiment of the present disclosure.
FIG. 8 is a diagram schematically illustrating a second graphite profile according to an embodiment of the present disclosure.
FIG. 9 is a diagram schematically illustrating the internal structure of a battery in which a negative electrode tab is disconnected according to an embodiment of the present disclosure.
FIG. 10 is a diagram schematically showing a method for diagnosing a battery according to another embodiment of the present disclosure.

### BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, preferred embodiments of the present disclosure will be described in detail with reference to the accompanying drawings.

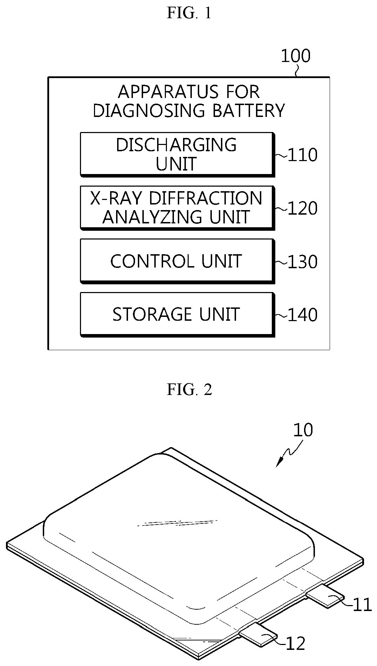

FIG. 1 is a diagram schematically illustrating an apparatus 100 for diagnosing a battery according to an embodiment of the present disclosure.

Referring to FIG. 1, the apparatus 100 for diagnosing a battery may include a voltage measuring unit 110, an X-ray diffraction analyzing unit 120 and a control unit 130.

Here, the battery means one physically separable independent cell having a negative electrode terminal and a positive electrode terminal. For example, a lithium-ion battery or a lithium polymer battery may be regarded as a battery.

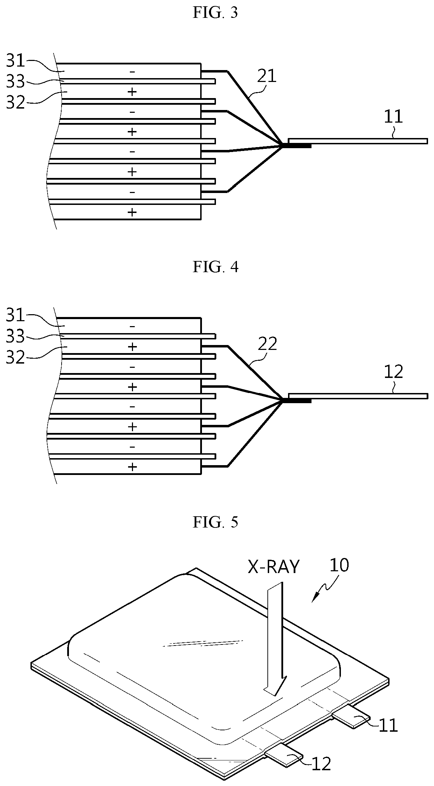

FIG. 2 is a diagram schematically illustrating a battery 10 according to an embodiment of the present disclosure. FIGS. 3 and 4 are diagrams schematically illustrating an internal structure of a battery 10 according to an embodiment of the present disclosure.

Referring to FIGS. 2 to 4, the battery 10 may include a cell assembly in which a negative electrode material 31, a separator 33, and a positive electrode material 32 are stacked. Also, a negative electrode tab 21 may be connected to the negative electrode material 31, and a positive electrode tab 22 may be connected to the positive electrode material 32. A plurality of negative electrode tabs 21 may be connected to the negative electrode lead 11, and a plurality of positive electrode material 32 may be connected to the positive electrode lead 12. FIG. 2 shows an embodiment in which the negative electrode lead 11 and the positive electrode lead 12 are located in the same direction, but the negative electrode lead 11 and the positive electrode lead 12 may be located in different directions depending on the embodiment.

The discharging unit 110 may be configured to be electrically connected to the battery 10.

Specifically, the discharging unit 110 may be connected to the negative electrode lead 11 and the positive electrode lead 12 of the battery 10, respectively. For example, in the embodiment of FIG. 2, the discharging unit 110 may be connected to the negative electrode lead 11 and the positive electrode lead 12.

The discharging unit 110 may be configured to discharge the battery 10.

For example, the discharging unit 110 may receive information about a discharge start signal and a discharge C-rate from the control unit 130. Also, the discharging unit 110 may discharge the battery 10 at a discharge C-rate corresponding to the received discharge C-rate information.

The X-ray diffraction analyzing unit 120 may be configured to output X-rays toward the plurality of negative electrode tabs 21 included in the battery 10.

Specifically, the X-ray diffraction analyzing unit 120 may be a component for irradiating X-rays to the battery 10 and diagnosing the state of the battery 10 using the diffracted rays. For example, the X-ray diffraction analyzing unit 120 may be configured to perform X-ray diffraction (XRD) analysis.

Preferably, the X-ray diffraction analyzing unit 120 may output X-rays toward the battery 10 periodically. That is, while the battery 10 is being discharged, the X-ray diffraction analyzing unit 120 may periodically output X-rays toward the battery 10.

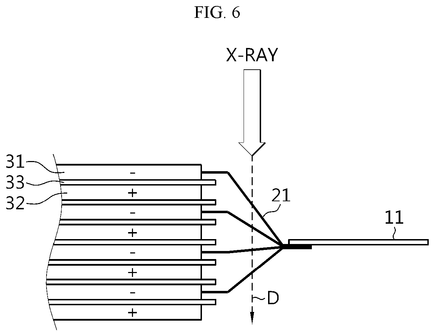

FIG. 5 and 6 are diagrams schematically illustrating examples in which X-rays are irradiated to a battery 10 according to an embodiment of the present disclosure.

For example, in the embodiment of FIG. 5, the X-ray diffraction analyzing unit 120 may output X-rays toward the battery 10. Specifically, in the embodiment of FIG. 6, the X-ray diffraction analyzing unit 120 may output X-rays toward the plurality of negative electrode tabs 21 included in the battery 10.

The X-ray diffraction analyzing unit 120 may be configured to generate a graphite profile for each of the plurality of negative electrode tabs 21 based on the output X-rays.

Specifically, the X-ray diffraction analyzing unit 120 may be configured to determine the integrated intensity of graphite for each of the plurality of negative electrode tabs 21 based on the diffraction information of the X-ray whenever X-ray is output.

Here, the integrated intensity is a value that can be obtained using an X-ray diffraction analysis method. The integrated intensity can be determined whenever an X-ray is output. For example, assuming that X-rays are output 10 times, 10 integrated intensities of graphite may be determined.

Preferably, the X-ray diffraction analyzing unit 120 may determine the integrated intensity of graphite in each of the plurality of negative electrode tabs 21 of the battery 10 while the battery 10 is being discharged. For example, in the embodiment of FIG. 3, the X-ray diffraction analyzing unit 120 may determine the integrated intensity of graphite for each of the plurality of negative electrode tabs 21. Since X-rays can pass through the negative electrode tab 21, the integrated intensity of graphite for each of the plurality of negative electrode tabs 21 can be determined.

In addition, the X-ray diffraction analyzing unit 120 may be configured to generate a graphite profile representing a correspondence between time and integrated intensity for each of the plurality of negative electrode tabs 21.

Specifically, the X-ray diffraction analyzing unit 120 may generate a graphite profile representing a change in integrated intensity over time. For example, the X-ray diffraction analyzing unit 120 may generate a graphite profile representing the determined plurality of integrated intensities over time (according to the order of X-ray irradiation cycles).

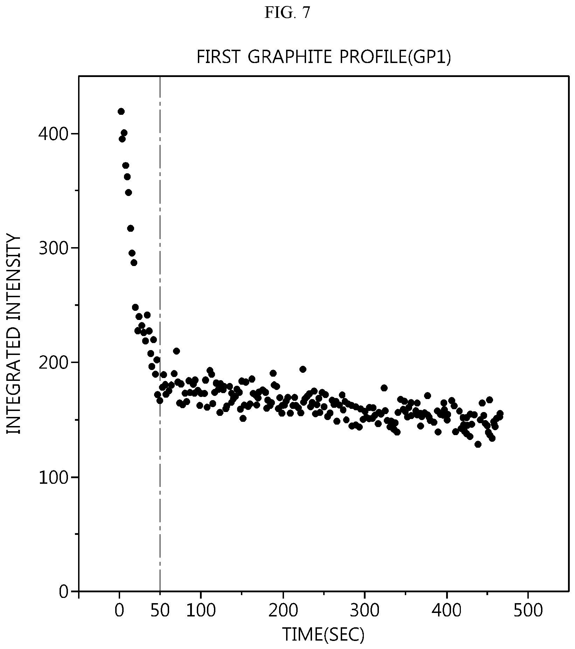

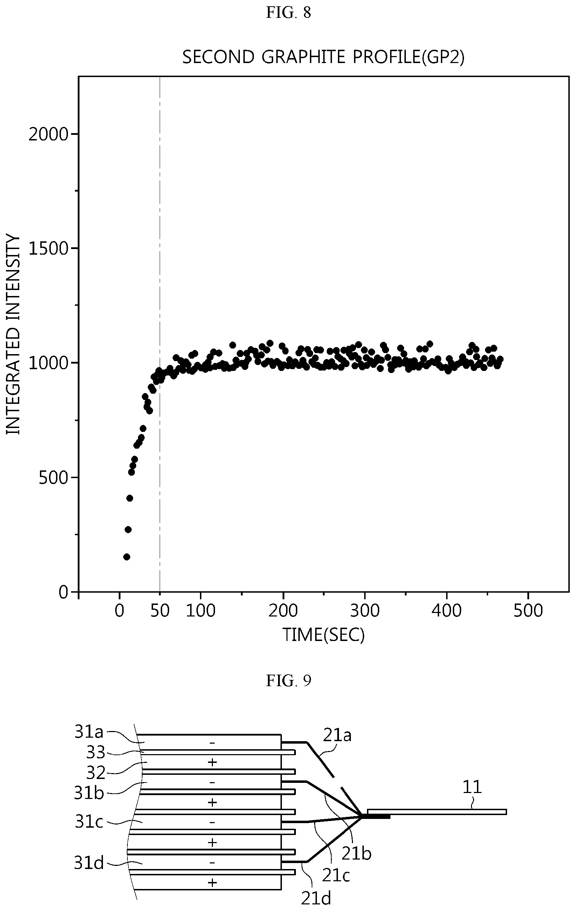

FIG. 7 is a diagram schematically illustrating a first graphite profile GP1 according to an embodiment of the present disclosure. FIG. 8 is a diagram schematically illustrating a second graphite profile GP2 according to an embodiment of the present disclosure.

For example, in the first graphite profile GP1, the integrated intensity of graphite decreases in a time period of less than 50 minutes, but in the second graphite profile GP2, the integrated intensity of graphite may increase in a time period of less than 50 minutes. That is, in the embodiments of FIGS. 7 and 8, charge and discharge behaviors of the negative electrode tab 21 may be different from each other in a time period of less than 50 minutes.

As a specific example, in the embodiment of FIG. 7, the negative electrode tab 21 may be discharged in a time period of less than 50 minutes, and may be in an idle state for a time period of 50 minutes or more. The first graphite profile GP1 may be a graphite profile for the negative electrode tab 21 discharged in a time period of 0 to 50 minutes.

Conversely, in the embodiment of FIG. 8, the negative electrode tab 21 may be charged in a time period of less than 50 minutes, and may be in an idle state in a time period of 50 minutes or more. The second graphite profile GP2 may be a graphite profile for the negative electrode tab 21 charged in a time period of 0 to 50 minutes.

The control unit 130 may be configured to determine charge and discharge behaviors of each of the plurality of negative electrode tabs 21 based on the generated plurality of graphite profiles.

Specifically, the control unit 130 may confirm the integrated intensity of graphite in each of the plurality of negative electrode tabs 21 based on the plurality of graphite profiles. In addition, the control unit 130 may be configured to determine the charge and discharge behaviors of each of the plurality of negative electrode tabs 21 as a charge behavior or a discharge behavior.

For example, the control unit 130 may confirm the increase or decrease of the integrated intensity of graphite over time in the graphite profile. Also, the control unit 130 may determine the charge and discharge behavior of the negative electrode tab 21 corresponding to the confirmed increase or decrease of the integrated intensity.

Specifically, the control unit 130 may be configured to determine the charge and discharge behavior of the negative electrode tab 21 in which the integrated intensity decreases as a discharge behavior. Conversely, the control unit 130 may be configured to determine the charge and discharge behavior of the negative electrode tab 21 in which the integrated intensity increases as a charge behavior.

In the embodiment of FIG. 7, looking at a time period of less than 50 minutes, the integrated intensity of graphite decreases over time. Accordingly, the control unit 130 may determine the charge and discharge behavior of the negative electrode tab 21 corresponding to the embodiment of FIG. 7 as a discharge behavior.

Conversely, in the embodiment of FIG. 8, looking at a time period of less than 50 minutes, the integrated intensity of graphite increases over time. Accordingly, the control unit 130 may determine the charge and discharge behavior of the negative electrode tab 21 corresponding to the embodiment of FIG. 8 as a charge behavior.

The control unit 130 may be configured to diagnose the state of the battery 10 based on the determined plurality of charge and discharge behaviors.

Specifically, the control unit 130 may determine the charge and discharge behavior for each of the plurality of negative electrode tabs 21. In addition, the control unit 130 may diagnose the state of the battery 10 according to whether the charge and discharge behaviors of the plurality of negative electrode tabs 21 match.

Preferably, the plurality of negative electrode tabs 21 included in the battery 10 should have the same charge and discharge behavior. That is, if some of the plurality of negative electrode tabs 21 included in the battery 10 have different charge and discharge behaviors, the state of the battery 10 may be an abnormal state. Accordingly, the control unit 130 may diagnose the state of the battery 10 as a normal state or an abnormal state in consideration of the charge and discharge behaviors of the plurality of negative electrode tabs 21.

For example, it is assumed that the first graphite profile GP1 according to the embodiment of FIG. 7 and the second graphite profile GP2 according to the embodiment of FIG. 8 are profiles for each of two negative electrode tabs 21 included in one battery 10. The control unit 130 may diagnose the state of the battery 10 as an abnormal state because the charge and discharge behaviors of the two negative electrode tabs 21 included in the battery 10 are different.

Preferably, the battery 10 diagnosed as being in an abnormal state by the control unit 130 may be disused to prevent accidents such as fire or explosion.

The apparatus 100 for diagnosing a battery according to an embodiment of the present disclosure may confirm charge and discharge behaviors of the plurality of negative electrode tabs 21 inside the battery using an X-ray diffraction analysis method. Furthermore, the apparatus 100 for diagnosing a battery may diagnose the state of the battery 10 by considering the charge and discharge behaviors of the plurality of negative electrode tabs 21. Therefore, the apparatus 100 for diagnosing a battery has an advantage of accurately diagnosing the state of the battery 10 in a non-destructive manner.

Meanwhile, the control unit 130 included in the apparatus 100 for diagnosing a battery may optionally include processors, application-specific integrated circuits (ASIC), other chipsets, logic circuits, registers, communication modems, data processing devices, etc. known in the art to execute various control logics performed in the present disclosure. Also, when the control logic is implemented as software, the control unit 130 may be implemented as a set of program modules. At this time, the program module may be stored in the memory and executed by the control unit 130. The memory may be inside or outside the control unit 130 and may be connected to the control unit 130 by various well-known means.

In addition, the apparatus 100 for diagnosing a battery may further include a storage unit 140. The storage unit 140 may store data necessary for operation and function of each component of the apparatus 100 for diagnosing a battery, data generated in the process of performing the operation or function, or the like. The storage unit 140 is not particularly limited in its kind as long as it is a known information storage means that can record, erase, update and read data. As an example, the information storage means may include RAM, flash memory, ROM, EEPROM, registers, and the like. In addition, the storage unit 140 may store program codes in which processes executable by the control unit 130 are defined.

Hereinafter, an embodiment in which the control unit 130 diagnoses the state of the battery 10 while the battery 10 is being discharged will be described in more detail.

The control unit 130 may be configured to diagnose the state of the battery 10 as a normal state when a discharge behavior is confirmed in the plurality of negative electrode tabs 21. Conversely, the control unit 130 may be configured to diagnose the state of the battery 10 as an abnormal state when a charge behavior is confirmed in at least one of the plurality of negative electrode tabs 21.

Preferably, when the battery 10 is being discharged, the plurality of negative electrode tabs 21 included in the battery 10 should have a discharge behavior. However, if a defect occurs inside the battery 10, even when the battery 10 is being discharged, at least one of the plurality of negative electrode tabs 21 may show a charge behavior.

Specifically, the control unit 130 may be configured to diagnose the state of the negative electrode tab 21 in which a charge behavior is confirmed as a disconnected state.

FIG. 9 is a diagram schematically illustrating the internal structure of a battery 10 in which a negative electrode tab 21 is disconnected according to an embodiment of the present disclosure.

Referring to FIG. 9, the first negative electrode tab 21a may be connected to the first negative electrode material 31a, and the second negative electrode tab 21b may be connected to the second negative electrode material 31b. The third negative electrode tab 21c may be connected to the third negative electrode material 31c, and the fourth negative electrode tab 21d may be connected to the fourth negative electrode material 31d. In a desirable case, when the battery 10 is discharged, the charge and discharge behaviors of the first negative electrode tab 21a, the second negative electrode tab 21b, the third negative electrode tab 21c, and the fourth negative electrode tab 21d should all be discharge behaviors. However, as in the embodiment of FIG. 9, when the first negative electrode tab 21a is disconnected, even if the battery 10 is discharged, the charge and discharge behavior of the first negative electrode tab 21a may be a charge behavior. That is, the graphite profile of the first negative electrode tab 21a may correspond to the second graphite profile GP2 of FIG. 8, and the graphite profiles of the second negative electrode tab 21b, the third negative electrode tab 21c, and the fourth negative electrode tab 21d may correspond to the first graphite profile GP1 of FIG. 7.

In the embodiment of FIG. 9, the second negative electrode material 31b, the third negative electrode material 31c, and the fourth negative electrode material 31d in which the negative electrode tab 21 is not disconnected may be electrically connected to the negative electrode lead 11. That is, when the battery 10 is discharged, lithium ions may be de-intercalated from the second negative electrode material 31b, the third negative electrode material 31c, and the fourth negative electrode material 31d. Specifically, lithium ions may be de-intercalated from graphite layers of the second negative electrode material 31b, the third negative electrode material 31c, and the fourth negative electrode material 31d by discharge. Here, since the first negative electrode tab 21a is disconnected, lithium ions are not de-intercalated from the graphite layer of the first negative electrode material 31a. Rather, lithium ions de-intercalated from the graphite layers of the second negative electrode material 31b, the third negative electrode material 31c, and the fourth negative electrode material 31d may migrate through the electrolyte and intercalate into the graphite layer of the first negative electrode material 31a. Therefore, even if the battery 10 is being discharged, the depth of charge of graphite can be increased in the disconnected first negative electrode tab 21a. Also, the increase in the depth of charge of the first negative electrode tab 21a can be confirmed from the increase in the integrated intensity of graphite of the first negative electrode tab 21a.

The apparatus 100 for diagnosing a battery according to an embodiment of the present disclosure has an advantage of accurately diagnosing whether or not the negative electrode tab 21 of the battery 10 is disconnected using an X-ray diffraction analysis method. That is, the apparatus 100 for diagnosing a battery has an advantage of not only diagnosing the state of the battery 10, but also specifically diagnosing the cause of the defect of the battery 10.

Meanwhile, the X-ray diffraction analyzing unit 120 may be configured to output X-rays in a direction through which the plurality of negative electrode tabs 21 pass.

Considering the characteristics of X-rays, X-rays output from the X-ray diffraction analyzing unit 120 may pass through the plurality of negative electrode tabs 21. In addition, the X-ray diffraction analyzing unit 120 should generate a graphite profile for each of the plurality of negative electrode tabs 21. Therefore, the X-ray diffraction analyzing unit 120 may output X-rays in a direction through which the plurality of negative electrode tabs 21 penetrate in order to generate a plurality of graphite profiles by reflecting the integrated intensity of graphite measured at the same time point.

For example, in the embodiment of FIG. 6, the D direction may be a direction through which the plurality of negative electrode tabs 21 pass. Accordingly, the X-ray diffraction analyzing unit 120 may output X-rays toward the plurality of negative electrode tabs 21 in the D direction.

In other words, the X-ray diffraction analyzing unit 120 may be configured to output X-rays in a stacking direction of the plurality of negative electrode tabs 21. In the embodiment of FIG. 6, since the plurality of negative electrode tabs 21 must be electrically connected to one negative electrode lead 11, ends of the plurality of negative electrode tabs 21 may be stacked to contact each other. Here, the stacking direction of the plurality of negative electrode tabs 21 may be the same as the D direction, which is a direction through which the plurality of negative electrode tabs 21 pass. Accordingly, the X-ray diffraction analyzing unit 120 may output X-rays toward the plurality of negative electrode tabs 21 in the D direction.

The apparatus 100 for diagnosing a battery according to an embodiment of the present disclosure may determine the integrated intensity of graphite for the plurality of negative electrode tabs 21 at the same time point, and generate a plurality of graphite profiles based on the determined integrated intensity. Accordingly, the accuracy and reliability of the battery condition diagnosis result by the apparatus 100 for diagnosing a battery can be improved.

A battery test device according to another embodiment of the present disclosure may include the apparatus 100 for diagnosing a battery according to an embodiment of the present disclosure.

For example, the battery test device may further include a fixing unit configured to fix the battery 10. When the battery 10 is fixed to the fixing unit, the discharging unit 110 can be connected to the negative electrode lead 11 and the positive electrode lead 12 of the battery 10. When receiving the discharge start signal and information about the discharge C-rate from the control unit 130, the discharging unit 110 may discharge the battery 10 at the corresponding C-rate. During the discharge process, the X-ray diffraction analyzing unit 120 may output X-rays to the battery 10 and generate a graphite profile for each of the plurality of negative electrode tabs 21. The control unit 130 may determine a charge and discharge behavior of each of the plurality of negative electrode tabs 21 by considering the plurality of graphite profiles. If the charge and discharge behavior of at least one negative electrode tab 21 is confirmed as a charge behavior, the control unit 130 may diagnose the state of the battery 10 as an abnormal state. In this case, the battery 10 diagnosed as being in an abnormal state may be disused.

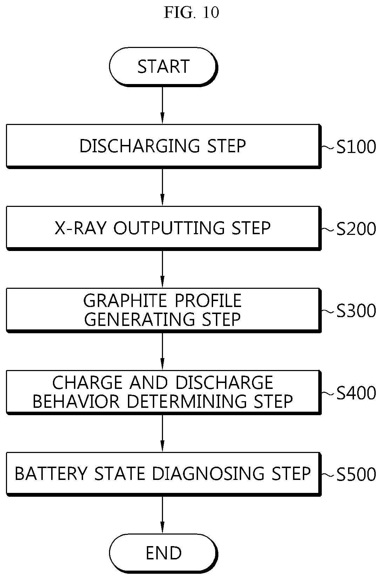

FIG. 10 is a diagram schematically showing a method for diagnosing a battery according to another embodiment of the present disclosure.

Preferably, each step of the method for diagnosing a battery may be performed by the apparatus 100 for diagnosing a battery. Hereinafter, for convenience of explanation, the content overlapping with the previously described content will be omitted or briefly described.

The method for diagnosing a battery may include a discharging step (S100), an X-ray outputting step (S200), a graphite profile generating step (S300), a charge and discharge behavior determining step (S400) and a battery state diagnosing step (S500).

The discharging step (S100) is a step of discharging the battery 10 and may be performed by the discharging unit 110.

The X-ray outputting step (S200) is a step of outputting X-rays toward the plurality of negative electrode tabs 21 included in the battery 10, and may be performed by the X-ray diffraction analyzing unit 120.

For example, the X-ray diffraction analyzing unit 120 may irradiate X-rays in a direction passing through the plurality of negative electrode tabs 21 included in the battery 10 (a direction in which the plurality of negative electrode tabs 21 are stacked).

The graphite profile generating step (S300) is a step of generating a graphite profile for each of the plurality of negative electrode tabs 21 based on the output X-ray, and may be performed by the X-ray diffraction analyzing unit 120.

The X-ray diffraction analyzing unit 120 may generate a graphite profile representing the integrated intensity of graphite over time for each of the plurality of negative electrode tabs 21.

The charge and discharge behavior determining step (S400) is a step of determining the charge and discharge behavior of each of the plurality of negative electrode tabs 21 based on the plurality of graphite profiles generated in the graphite profile generating step (S300), and may be performed the control unit 130.

Specifically, the control unit 130 may determine the charge and discharge behavior of each of the plurality of negative electrode tabs 21 based on the increase or decrease of the integrated intensity of graphite appearing in the graphite profile.

For example, the control unit 130 may determine the charge and discharge behavior of the negative electrode tab 21 in which the integrated intensity of graphite increases over time as a charge behavior. Conversely, the control unit 130 may determine the charge and discharge behavior of the negative electrode tab 21 in which the integrated intensity of graphite decreases over time as a discharge behavior.

The battery state diagnosing step (S500) is a step of diagnosing the state of the battery 10 based on the determined plurality of charge and discharge behaviors, and may be performed by the control unit 130.

Specifically, the control unit 130 may diagnose the state of the battery 10 as an abnormal state when the charge and discharge behavior of at least one of the plurality of negative electrode tabs 21 is the charge behavior. More specifically, the control unit 130 may diagnose that the negative electrode tab 21 in which the charge and discharge behavior is the charge behavior is disconnected.

The present disclosure has been described in detail. However, it should be understood that the detailed description and specific examples, while indicating preferred embodiments of the disclosure, are given by way of illustration only.

### (Explanation of reference signs)

10: battery
11: negative electrode lead
12: positive electrode lead
21: negative electrode tab
22: positive electrode tab
31: negative electrode material
32: positive electrode material
33: separator
100: apparatus for diagnosing a battery
110: discharging unit
120: X-ray diffraction analyzing unit
130: control unit
140: storage unit

## Claims

1. An apparatus (100) for diagnosing a battery (10), comprising:
a discharging unit (110) electrically connected to a battery (10) and configured to discharge the battery (10);
an X-ray diffraction analyzing unit (120) configured to output, while the battery (10) is discharging, an X-ray toward a plurality of negative electrode tabs (21) included in the battery (10) and generate a graphite profile for each of the plurality of negative electrode tabs (21) based on the output X-ray; and
a control unit (130) configured to determine a charge and discharge behavior of each of the plurality of negative electrode tabs (21) based on the generated plurality of graphite profiles, and diagnose the state of the battery (10) based on the determined plurality of charge and discharge behaviors.

2. The apparatus (100) for diagnosing a battery (10) according to claim 1, wherein the control unit (130) is configured to determine the charge and discharge behavior of each of the plurality of negative electrode tabs (21) as a charge behavior or a discharge behavior by checking an integrated intensity of graphite in each of the plurality of negative electrode tabs (21) based on the plurality of graphite profiles.

3. The apparatus (100) for diagnosing a battery (10) according to claim 2, wherein the control unit (130) is configured to determine the charge and discharge behavior of the negative electrode tab (21, 21a-d) in which the integrated intensity decreases as the discharge behavior, and to determine the charge and discharge behavior of the negative electrode tab (21, 21a-d) in which the integrated intensity increases as the charge behavior.

4. The apparatus (100) for diagnosing a battery (10) according to claim 2, wherein when the discharge behavior is confirmed in the plurality of negative electrode tabs (21), the control unit (130) is configured to diagnose the state of the battery (10) as a normal state, and
wherein when the charge behavior is confirmed in at least one of the plurality of negative electrode tabs (21), the control unit (130) is configured to diagnose the state of the battery (10) as an abnormal state.

5. The apparatus (100) for diagnosing a battery (10) according to claim 4, wherein the control unit (130) is configured to diagnose the state of the negative electrode tab (21, 21a-d) in which the charge behavior is confirmed as a disconnected state.

6. The apparatus (100) for diagnosing a battery (10) according to claim 1, wherein the X-ray diffraction analyzing unit (120) is configured to output the X-ray in a direction through which the plurality of negative electrode tabs (21) pass.

7. The apparatus (100) for diagnosing a battery (10) according to claim 1, wherein the X-ray diffraction analyzing unit (120) is configured to output the X-ray in a stacking direction of the plurality of negative electrode tabs (21).

8. The apparatus (100) for diagnosing a battery (10) according to claim 1,
wherein the X-ray diffraction analyzing unit (120) is configured to determine an integrated intensity of graphite for each of the plurality of negative electrode tabs (21) based on diffraction information of the X-ray whenever the X-ray is output, and to generate the graphite profile representing the correspondence between time and the integrated intensity for each the plurality of negative electrode tabs (21).

9. A battery test device, comprising the apparatus (100) for diagnosing a battery (10) according to any one of claims 1 to 8.

10. A method for diagnosing a battery (10), comprising:
a discharging step of discharging a battery (10);
an X-ray outputting step of outputting, while the battery (10) is discharging, an X-ray toward a plurality of negative electrode tabs (21) included in the battery (10);
a graphite profile generating step of generating a graphite profile for each of the plurality of negative electrode tabs (21) based on the output X-ray;
a charge and discharge behavior determining step of determining a charge and discharge behavior of each of the plurality of negative electrode tabs (21) based on the plurality of graphite profiles generated in the graphite profile generating step; and
a battery state diagnosing step of diagnosing the state of the battery (10) based on the determined plurality of charge and discharge behaviors.

## Patentansprüche

1. Vorrichtung (100) zum Diagnostizieren einer Batterie (10), umfassend:
eine Entladeeinheit (110), die elektrisch mit einer Batterie (10) verbunden ist und konfiguriert ist, um die Batterie (10) zu entladen;
eine Röntgenbeugungsanalyseeinheit (120), die konfiguriert ist, um, während die Batterie (10) entladen wird, einen Röntgenstrahl an eine Vielzahl von negativen Elektrodenstreifen (21), die in der Batterie (10) enthalten sind, auszugeben und ein Graphitprofil für jeden der Vielzahl von negativen Elektrodenstreifen (21) basierend auf dem ausgegebenen Röntgenstrahl zu erzeugen; und
eine Steuereinheit (130), die konfiguriert ist, um ein Lade- und Entladeverhalten jedes der Vielzahl von negativen Elektrodenstreifen (21) basierend auf der erzeugten Vielzahl von Graphitprofilen zu bestimmen und den Zustand der Batterie (10) basierend auf der bestimmten Vielzahl von Lade- und Entladeverhalten zu diagnostizieren.

2. Vorrichtung (100) zum Diagnostizieren einer Batterie (10) nach Anspruch 1, wobei die Steuereinheit (130) konfiguriert ist, um das Lade- und Entladeverhalten jedes der Vielzahl von negativen Elektrodenstreifen (21) als ein Ladeverhalten oder ein Entladeverhalten durch Prüfen einer integrierten Intensität von Graphit in jedem der Vielzahl von negativen Elektrodenstreifen (21) basierend auf der Vielzahl von Graphitprofilen zu bestimmen.

3. Vorrichtung (100) zum Diagnostizieren einer Batterie (10) nach Anspruch 2, wobei die Steuereinheit (130) konfiguriert ist, um das Lade- und Entladeverhalten des negativen Elektrodenstreifens (21, 21a-d), in dem die integrierte Intensität abnimmt, als das Entladeverhalten zu bestimmen und das Lade- und Entladeverhalten des negativen Elektrodenstreifens (21, 21a-d), in dem die integrierte Intensität zunimmt, als das Ladeverhalten zu bestimmen.

4. Vorrichtung (100) zum Diagnostizieren einer Batterie (10) nach Anspruch 2, wobei, wenn das Entladeverhalten in der Vielzahl von negativen Elektrodenstreifen (21) bestätigt wird, die Steuereinheit (130) konfiguriert ist, um den Zustand der Batterie (10) als einen Normalzustand zu diagnostizieren, und
wobei, wenn das Ladeverhalten in mindestens einem der Vielzahl von negativen Elektrodenstreifen (21) bestätigt wird, die Steuereinheit (130) konfiguriert ist, um den Zustand der Batterie (10) als einen anormalen Zustand zu diagnostizieren.

5. Vorrichtung (100) zum Diagnostizieren einer Batterie (10) nach Anspruch 4, wobei die Steuereinheit (130) konfiguriert ist, um den Zustand des negativen Elektrodenstreifens (21, 21a-d), in dem das Ladeverhalten bestätigt wird, als einen getrennten Zustand zu diagnostizieren.

6. Vorrichtung (100) zum Diagnostizieren einer Batterie (10) nach Anspruch 1, wobei die Röntgenbeugungsanalyseeinheit (120) konfiguriert ist, um den Röntgenstrahl in einer Richtung auszugeben, in der die Vielzahl von negativen Elektrodenstreifen (21) verläuft.

7. Vorrichtung (100) zum Diagnostizieren einer Batterie (10) nach Anspruch 1, wobei die Röntgenbeugungsanalyseeinheit (120) konfiguriert ist, um den Röntgenstrahl in einer Stapelrichtung der Vielzahl von negativen Elektrodenstreifen (21) auszugeben.

8. Vorrichtung (100) zum Diagnostizieren einer Batterie (10) nach Anspruch 1,
wobei die Röntgenbeugungsanalyseeinheit (120) konfiguriert ist, um eine integrierte Intensität von Graphit für jeden der Vielzahl von negativen Elektrodenstreifen (21) basierend auf Beugungsinformationen des Röntgenstrahls zu bestimmen, wann immer der Röntgenstrahl ausgegeben wird, und um das Graphitprofil zu erzeugen, das die Entsprechung zwischen der Zeit und der integrierten Intensität für jeden der Vielzahl von negativen Elektrodenstreifen (21) darstellt.

9. Batterietestvorrichtung, umfassend die Vorrichtung (100) zum Diagnostizieren einer Batterie (10) nach einem der Ansprüche 1 bis 8.

10. Verfahren zum Diagnostizieren einer Batterie (10), umfassend:
einen Entladeschritt des Entladens einer Batterie (10);
einen Röntgenstrahlausgabeschritt des Ausgebens, während die Batterie (10) entladen wird, eines Röntgenstrahls an eine Vielzahl von negativen Elektrodenstreifen (21), die in der Batterie (10) enthalten sind;
einen Graphitprofilerzeugungsschritt des Erzeugens eines Graphitprofils für jeden der Vielzahl von negativen Elektrodenstreifen (21) basierend auf dem ausgegebenen Röntgenstrahl;
einen Lade- und Entladeverhalten-Bestimmungsschritt des Bestimmens eines Lade- und Entladeverhaltens jedes der Vielzahl von negativen Elektrodenstreifen (21) basierend auf der Vielzahl von Graphitprofilen, die in dem Graphitprofilerzeugungsschritt erzeugt werden; und
einen Batteriezustand-Diagnoseschritt des Diagnostizierens des Zustands der Batterie (10) basierend auf der bestimmten Vielzahl von Lade- und Entladeverhalten.

## Revendications

1. Appareil (100) de diagnostic d'une batterie (10), comprenant:
un dispositif de décharge (110) connecté électriquement à une batterie (10), et configuré pour décharger la batterie (10) ;
un module d'analyse par DRX (120) configuré pour émettre, au cours de la décharge de la batterie (10), un rayonnement X vers une pluralité de languettes d'électrode négative (21) incorporés dans la batterie (10) et générer un profil de graphite pour chacune de la pluralité de languettes d'électrode négative (21) en fonction du rayonnement X émis ; et
un module de commande (130) configuré pour déterminer un comportement de charge et décharge de chacune de la pluralité de languettes d'électrode négative (21) d'après la pluralité générée de profils de graphite, et diagnostiquer l'état de la batterie (10) en fonction de la pluralité déterminée de comportements de charge et décharge.

2. Appareil (100) de diagnostic d'une batterie (10) selon la revendication 1, le module de commande (130) étant configuré pour déterminer le comportement de charge et décharge de chacune de la pluralité de languettes d'électrode négative (21) en tant que comportement de charge ou comportement de décharge, en vérifiant une intensité intégrée de graphite dans chacune de la pluralité de languettes d'électrode négative (21) d'après la pluralité de profils de graphite.

3. Appareil (100) de diagnostic d'une batterie (10) selon la revendication 2, le module de commande (130) étant configuré pour déterminer le comportement de charge et décharge de la languette d'électrode négative (21, 21a-d) dans laquelle l'intensité intégrée diminue en tant que comportement de décharge, et pour déterminer le comportement de charge et décharge de la languette d'électrode négative (21, 21a-d) dans laquelle l'intensité intégrée augmente en tant que comportement de charge.

4. Appareil (100) de diagnostic d'une batterie (10) selon la revendication 2, le comportement de décharge étant confirmé dans la pluralité de languettes d'électrode négative (21), le module de commande (130) étant configuré pour diagnostiquer l'état de la batterie (10) comme un état normal, et
lorsque le comportement de charge est confirmé dans au moins une de la pluralité de languettes d'électrode négative (21), le module de commande (130) étant configuré pour diagnostiquer l'état de la batterie (10) en tant qu'état anormal.

5. Appareil (100) de diagnostic d'une batterie (10) selon la revendication 4, le module de commande (130) étant configuré pour diagnostiquer l'état de la languette d'électrode négative (21, 21a-d) dans laquelle le comportement de charge est confirmé en tant qu'état déconnecté.

6. Appareil (100) de diagnostic d'une batterie (10) selon la revendication 1, le module d'analyse par DRX (120) étant configuré pour émettre le rayonnement X dans une direction à travers laquelle passent la pluralité de languettes d'électrode négative (21).

7. Appareil (100) de diagnostic d'une batterie (10) selon la revendication 1, le module d'analyse par DRX (120) étant configuré pour émettre le rayonnement X dans une direction d'empilement de la pluralité de languettes d'électrode négative

8. Appareil (100) de diagnostic d'une batterie (10) selon la revendication 1,
le module d'analyse par DRX (120) étant configuré pour déterminer une intensité intégrée du graphite pour chacune de la pluralité de languettes d'électrode négative (21) d'après des informations de diffraction du rayonnement X à chaque émission d'un rayonnement X, et pour générer le profil de graphite représentant la correspondance entre le temps et l'intensité intégrée pour chacune de la pluralité de languettes d'électrode négative (21).

9. Dispositif de test de batterie comprenant l'appareil (100) de diagnostic d'une batterie (10) selon une quelconque des revendications 1 à 8.

10. Procédé de diagnostic d'une batterie (10) comprenant :
une étape de décharge comportant la décharge d'une batterie (10) ;
une étape d'émission d'un rayonnement X, comportant l'émission, pendant la décharge de la batterie (10), d'un rayonnement X vers une pluralité de languettes d'électrode négative (21) comprises dans la batterie (10) ;
une étape de génération d'un profil de graphite comportant la génération d'un profil de graphite pour chacune de la pluralité de languettes d'électrode négative (21) d'après l'émission d'un rayonnement X ;
une étape de détermination d'un comportement de charge et décharge comportant la détermination d'un comportement de charge et décharge de chacune de la pluralité de languettes d'électrode négative (21) d'après la pluralité de profils de graphite générés à l'étape de génération d'un profil de graphite ; et
une étape de diagnostic de l'état de la batterie comportant le diagnostic de l'état de la batterie (10) d'après la pluralité déterminée de comportements de charge et décharge.
